# FASCICULE DE BREVET EUROPEEN

(11) **EP 3 601 634 B1**
(45) Date de publication et mention de la délivrance du brevet: **13.01.2021**
(21) Numéro de dépôt: 18723899.3
(22) Date de dépôt: 30.03.2018
(51) Int. Cl.: C23C 28/00, F01D 5/28, C23C 14/16, C23C 14/02

(54) **PIECE DE TURBINE EN SUPERALLIAGE ET PROCEDE DE FABRICATION ASSOCIE**
TURBINENKOMPONENTE AUS SUPERLEGIERUNG UND ZUGEHÖRIGES HERSTELLUNGSVERFAHREN
TURBINE COMPONENT MADE FROM SUPERALLOY AND ASSOCIATED MANUFACTURING METHOD

(30) Priorité: 30.03.2017 FR 1700347
(43) Date de publication de la demande: 05.02.2020
(73) Titulaire: Safran, 75015 Paris (FR)
(72) Inventeur: SABOUNDJI, Amar, 77550 Moissy-Cramayel (FR); JAQUET, Virginie, 77550 Moissy-Cramayel (FR)
(74) Mandataire: Regimbeau
(86) Numéro de dépôt international: PCT/FR2018/050814
(87) Numéro de publication internationale: WO 2018/178603

(56) Documents cités:
- EP-A1- 1 652 964
- WO-A1-2014/143257
- US-A1- 2004 229 075

## Description

### DOMAINE DE L'INVENTION

L'invention concerne une pièce de turbine, telle qu'une aube de turbine ou une ailette de distributeur par exemple, utilisée dans l'aéronautique.

### ETAT DE LA TECHNIQUE

Dans un turboréacteur, les gaz d'échappement générés par la chambre de combustion peuvent atteindre des températures élevées, supérieure à 1200°C, voire 1600°C. Les pièces du turboréacteur, en contact avec ces gaz d'échappement, telles que les aubes de turbine par exemple, doivent ainsi être capables de conserver leurs propriétés mécaniques à ces températures élevées.

A cet effet, il est connu de fabriquer certaines pièces du turboréacteur en « superalliage ». Les superalliages constituent une famille d'alliages métalliques à haute résistance pouvant travailler à des températures relativement proches de leurs points de fusion (typiquement 0,7 à 0,8 fois leurs températures de fusion).

Afin de renforcer la résistance thermique de ces superalliages et de les protéger contre l'oxydation et la corrosion, il est connu de les recouvrir d'un revêtement jouant un rôle de barrière thermique. EP 1 652 964 divulgue une pièce de turbine comprenant un substrat en superalliage base nickel monocristallin et une couche métallique sur le substrat. La couche métallique comprend la phase γ'-Ni3Al et la teneur en aluminium correspond à la teneur dans le substrat.

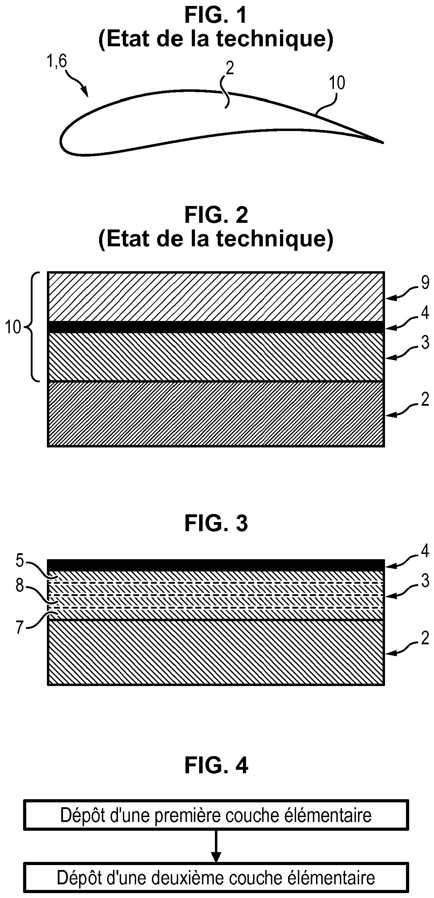

La figure 1 illustre schématiquement une section d'une pièce de turbine 1, par exemple une aube 6 de turbine ou une ailette de distributeur. La pièce 1 comprend un substrat 2 en superalliage métallique monocristallin recouvert d'une barrière thermique 10.
La figure 2 illustre schématiquement une section d'une partie de la barrière thermique de la pièce de turbine 1, recouvrant un substrat. La barrière thermique comprend une sous-couche métallique 3, une couche protectrice 4 et une couche thermiquement isolante 9. La sous-couche métallique 3, recouvre le substrat 2 en superalliage métallique. La sous-couche 3 métallique est elle-même recouverte de la couche protectrice 4, formée par oxydation de la sous-couche métallique 3. La couche protectrice 4 permet de protéger le substrat en superalliage de la corrosion et/ou de l'oxydation. La couche thermiquement isolante 9 recouvre la couche protectrice 4. La couche thermiquement isolante peut être en céramique, par exemple en zircone yttriée.

La sous-couche 3 métallique assure une liaison entre la surface du substrat en superalliage et la couche protectrice : la sous-couche métallique est parfois appelée « sous-couche d'accroche ». Il existe deux grandes familles de sous-couches métalliques.

La première famille de sous-couches métalliques regroupe les sous-couches à base d'aluminure de nickel simple β-NiAl ou modifié platine β-NiAlPt.

Dans le cas d'une sous-couche d'aluminure de nickel simple ou modifié platine (β-NiAl ou β-NiAlPt), la teneur en aluminium (35-45 % at) de la sous-couche est suffisante pour former exclusivement une couche protectrice d'oxyde d'aluminium (Al₂O₃) permettant de protéger le substrat en superalliage contre l'oxydation et la corrosion.

Toutefois, lorsque la pièce est soumise à des hautes températures, la différence des concentrations en nickel, et surtout en aluminium, entre le substrat en superalliage et la sous-couche métallique provoque la diffusion de nickel dans la sous-couche et celle de l'aluminium dans le superalliage (phénomène appelé « inter-diffusion »).

Par ailleurs, de l'aluminium est également consommé pour former la couche protectrice d'oxyde d'aluminium.

Ces phénomènes entraînent un appauvrissement prématuré de la sous-couche en aluminium, ce qui favorise des transformations de phases dans la sous-couche (β-NiAl → γ'-Ni₃Al, transformation martensitique). Ces transformations génèrent des fissures dans la sous-couche et favorisent l'écaillage de la couche d'oxyde d'aluminium.

De plus, la diffusion de certains éléments du superalliage, comme le titane, ou de certaines impuretés, comme le soufre, entraine une dégradation de l'adhérence de la couche d'oxyde d'aluminium.

Enfin, l'inter-diffusion peut entraîner la formation de zones de réaction secondaire (appelées « SRZ » ou « Secondary Reaction Zone » en anglais) qui dégradent fortement les propriétés mécaniques (fluage, fatigue) du superalliage revêtu.

Ainsi, les inter-diffusions entre le substrat en superalliage et la sous-couche peuvent avoir des conséquences néfastes sur la durée de vie de la pièce en superalliage.

La deuxième famille de sous-couches métalliques regroupe les sous-couches à base γ-(Ni)+γ'-(Ni3Al) simples ou modifiés platine.

Ces sous-couches ont pour avantage de limiter les conséquences néfastes de l'inter-diffusion et ainsi d'augmenter la durée de vie des superalliages revêtus.

En effet, ces sous-couches ont une composition chimique proche de celle des superalliages, ce qui leur permet de résister aux phénomènes d'inter-diffusion à haute température et de limiter les phénomènes d'ondulation de surface (ou *rumpling* en anglais) qui endommagent la barrière thermique.

Grâce à une composition chimique proche de celle des superalliages, ces sous-couches limitent également la formation des zones de réaction secondaire (SRZ).

En revanche, un inconvénient de ces sous-couches est leur faible teneur en aluminium (15 à 20 % at), qui ne leur permet pas de former une couche protectrice en oxyde d'aluminium capable de subsister pendant toute la durée de vie d'un turboréacteur. Lors de l'utilisation de la turbine, la couche protectrice 4 peut s'écailler et/ou être détériorée : la sous-couche 3 est alors oxydée de manière à former une nouvelle couche protectrice 4 ou une nouvelle partie de couche protectrice 4. La sous-couche métallique 3 est un réservoir d'aluminium permettant la formation en surface d'oxyde d'aluminium : lors de la diminution, par exemple jusqu'à épuisement, de la quantité d'aluminium disponible dans la sous-couche métallique 3, et il n'est plus possible de former une nouvelle couche protectrice 4. Un écaillage de la couche protectrice est par exemple observé à partir de deux cents heures d'utilisation.

Ainsi, au final, ces types de sous-couches métalliques peuvent présenter des performances en termes de résistance à l'oxydation et à la corrosion bien inférieures à celles des sous-couches métalliques de type β-NiAlPt.

### RESUME DE L'INVENTION

Un but de l'invention est de proposer une solution pour protéger efficacement une pièce de turbine en superalliage de l'oxydation et de la corrosion tout en présentant une durée de vie plus longue qu'avec les sous-couches métalliques connues.

Ce but est atteint dans le cadre de la présente invention grâce à une pièce de turbine comprenant :
- un substrat en superalliage base nickel monocristallin, et
- une sous-couche métallique recouvrant le substrat,
caractérisée en ce que la sous-couche comprend au moins deux couches élémentaires, incluant une première couche élémentaire et une deuxième couche élémentaire, la première couche élémentaire étant disposée entre le substrat et la deuxième couche élémentaire, chaque couche élémentaire comprenant une phase γ'-Ni₃Al et en ce que la fraction atomique moyenne en aluminium de la deuxième couche élémentaire est strictement supérieure à la fraction atomique moyenne en aluminium de la première couche élémentaire.

Comme la sous-couche métallique est formée de plusieurs couches élémentaires, il est possible de faire varier progressivement la concentration en aluminium d'une couche élémentaire à l'autre, de manière à limiter les phénomènes d'inter-diffusion entre deux couches élémentaires.

De plus, la concentration en aluminium de la deuxième couche élémentaire peut être choisie de manière à former une couche protectrice en oxyde d'aluminium présentant une durée de vie supérieure à celle des sous-couches métalliques connus de la deuxième famille.

L'invention est avantageusement complétée par les caractéristiques suivantes, prises individuellement ou en l'une quelconque de leurs combinaisons techniquement possibles :
- au moins un couche élémentaire comprend une phase y-Ni ;
- la fraction atomique moyenne en aluminium de la première couche élémentaire est strictement supérieure à la fraction atomique moyenne en aluminium du substrat ;
- la première couche élémentaire comprend une phase γ'-Ni₃Al et une phase y-Ni, et la sous-couche métallique comprend au moins une autre couche élémentaire comprenant uniquement une phase y-Ni ;
- la sous-couche métallique comprend une pluralité de couches élémentaires, chaque couche élémentaire comprend une phase γ'-Ni₃Al, ainsi qu'éventuellement une phase γ-Ni, et la fraction atomique moyenne en aluminium des couches élémentaires va en augmentant à mesure que l'on s'éloigne du substrat ;
- la fraction atomique moyenne en aluminium de la couche élémentaire la plus éloignée du substrat est comprise entre 0,22 et 0,35 ;
- la fraction atomique moyenne en aluminium de la couche élémentaire la plus proche du substrat est inférieure à 0,2 ;
- la différence entre la fraction atomique moyenne en aluminium du substrat et la fraction atomique moyenne en aluminium de la couche élémentaire la plus proche du substrat est inférieure à 0,08 ;
- la différence entre la fraction atomique moyenne en aluminium de deux couches élémentaires successives est inférieure à 0,06 ;
- chaque couche élémentaire comprend au moins un additif choisi parmi du chrome et du hafnium, et la fraction atomique moyenne en additif des couches élémentaires va en augmentant à mesure que l'on s'éloigne du substrat ;
- chaque couche élémentaire comprend du hafnium et la différence entre la fraction atomique moyenne en hafnium de deux couches élémentaires successives est inférieure à 0,001 ;
- la fraction atomique moyenne en hafnium de la couche élémentaire la plus éloignée du substrat est inférieure à 0,03 et la fraction atomique moyenne en hafnium de la couche élémentaire la plus proche du substrat est supérieure à 0,0005.

Ce but est également atteint dans le cadre de la présente invention grâce à un procédé de fabrication d'une pièce de turbine comprenant des étapes de:
- dépôt d'une première couche élémentaire comprenant une phase y'-Ni₃Al, ainsi qu'éventuellement une phase y-Ni, et présentant une fraction atomique moyenne en aluminium x₁, sur un substrat en superalliage métallique à base nickel monocristallin;
- dépôt d'une deuxième couche élémentaire comprenant une phase y'-Ni₃Al, ainsi qu'éventuellement une phase -Ni, et présentant une fraction atomique moyenne en aluminium x₂ strictement supérieure à x₁ sur la première couche élémentaire.

La première couche élémentaire peut présenter une fraction atomique moyenne en aluminium x₁ strictement supérieure à la fraction atomique moyenne en aluminium x₀ du superalliage base nickel du substrat.

### PRESENTATION DES DESSINS

D'autres caractéristiques et avantages ressortiront encore de la description qui suit, laquelle est purement illustrative et non limitative, et doit être lue en regard des figures annexées, parmi lesquelles :
- la figure 1 illustre schématiquement une section d'une pièce de turbine, par exemple une aube de turbine ou une ailette de distributeur ;
- la figure 2 illustre schématiquement une section d'une partie de la barrière thermique de la pièce de turbine ;
- la figure 3 illustre de manière schématique un substrat 2 recouvert d'une sous-couche selon un mode de réalisation de l'invention et
- la figure 4 illustre de manière schématique un procédé de fabrication d'une pièce 1 de turbine.

### DEFINITIONS

On désigne par le terme « superalliage » un alliage complexe présentant, à haute température et à haute pression, une très bonne résistance à l'oxydation, à la corrosion, au fluage et à des contraintes cycliques (notamment mécaniques ou thermiques). Les superalliages trouvent une application particulière dans la fabrication de pièces utilisées dans l'aéronautique, par exemple des aubes de turbine, car ils constituent une famille d'alliages à haute résistance pouvant travailler à des températures relativement proches de leurs points de fusion (typiquement 0,7 à 0,8 fois leurs températures de fusion).

Un superalliage présente une microstructure biphasique comprenant une première phase (appelée « phase γ ») formant une matrice, et une deuxième phase (appelée « phase γ' ») formant des précipités durcissant dans la matrice.

La « base » du superalliage désigne le composant métallique principal de la matrice. Dans la majorité des cas, les superalliages comprennent une base fer, cobalt, ou nickel, mais également parfois une base titane ou aluminium.

Les « superalliages base nickel » présentent l'avantage d'offrir un bon compromis entre résistance à l'oxydation, résistance à la rupture à haute température et poids, ce qui justifie leur emploi dans les parties les plus chaudes des turboréacteurs.

Les superalliages base nickel sont constitués d'une phase γ (ou matrice) de type austénitique cubique à face centrée γ-Ni, contenant éventuellement des additifs en solution solide de substitution α (Co, Cr, W, Mo), et d'une phase γ' (ou précipités) de type γ'-Ni₃X, avec X = Al, Ti ou Ta. La phase γ' possède une structure L₁₂ ordonnée, dérivée de la structure cubique à face centrée, cohérente avec la matrice, c'est-à-dire ayant une maille atomique très proche de celle-ci.

De par son caractère ordonné, la phase γ' présente la propriété remarquable d'avoir une résistance mécanique qui augmente avec la température jusqu'à 800°C environ. La cohérence très forte entre les phases γ et γ' confère une tenue mécanique à chaud très élevée des superalliages à base nickel, qui dépend elle-même du ratio γ/γ' et de la taille des précipités durcissants.

Les superalliages base nickel présentent ainsi généralement une forte résistance mécanique jusqu'à 700°C, puis une résistance mécanique qui diminue fortement au-delà de 800°C.

Les termes « fraction atomique » désignent la concentration. L'ensemble des concentrations sont exprimées en concentration atomique (% at).

### DESCRIPTION DETAILLEE DE L'INVENTION

En référence à la figure 3, un substrat 2 est recouvert d'une barrière thermique.

Les éléments illustrés en figure 3 peuvent être indépendamment représentatifs des éléments d'une aube de turbine, d'une ailette de distributeur, ou de tout autre élément, partie ou pièce d'une turbine.

Le substrat 2 est formé en superalliage à base nickel.

La barrière thermique comprend une sous-couche métallique 3, une couche protectrice 4 et une couche thermiquement isolante (non représentée dans la figure 3).

Le substrat 2 est recouvert par la sous-couche 3 métallique, elle-même recouverte par la couche protectrice 4.

Selon un aspect de l'invention, la sous-couche 3 métallique comprend au moins deux couches élémentaires 5. La figure 3 illustre un mode de réalisation dans lequel la sous-couche 3 comporte quatre couches élémentaires 5.

De manière générale, la ou les interfaces entre les couches élémentaires 5 ont pour avantage de limiter ou d'empêcher la diffusion de métal et/ou d'oxygène à haute température entre les couches élémentaires et ainsi de limiter ou d'empêcher un phénomène d'inter-diffusion.

La sous-couche 3 comprend notamment une première couche élémentaire 7 et une deuxième couche élémentaire 8. La première couche élémentaire 7 est disposée entre le substrat 2 et la deuxième couche élémentaire 8. De manière générale, la fraction atomique moyenne en aluminium de la deuxième couche élémentaire 8 est strictement supérieure à la fraction atomique moyenne en aluminium de la première couche élémentaire 7.

Ainsi, un gradient de fraction atomique en aluminium peut-être généré dans une sous-couche 3.

De manière générale, chaque couche élémentaire comprend une phase γ'-Ni₃Al ainsi qu'éventuellement une phase γ-Ni.

Selon un aspect de l'invention, la première couche élémentaire comprend une phase γ'-Ni₃Al et une phase γ-Ni, et une autre couche élémentaire comprend uniquement une phase γ-Ni. Avantageusement, une pluralité de couches élémentaires comprend une phase γ'-Ni₃Al et une phase γ-Ni, et une pluralité de couches élémentaires comprend uniquement une phase γ-Ni. La fraction atomique moyenne en aluminium des couches élémentaires va en augmentant à mesure que l'on s'éloigne du substrat ; autrement dit, un gradient positif de la fraction atomique en aluminium, selon un sens dirigé du substrat vers la couche protectrice 4, peut être ainsi généré dans la sous-couche 3.

Cette caractéristique entraîne deux effets de manière concomitante :
- la fraction atomique moyenne en aluminium de la couche élémentaire 5 la plus éloignée du substrat est suffisante pour former exclusivement une couche protectrice 4 d'oxyde d'aluminium de manière à protéger le substrat 2 en superalliage contre l'oxydation et la corrosion, et
- la fraction atomique moyenne en aluminium de la couche élémentaire 7 la plus proche du substrat est suffisamment faible pour limiter la diffusion d'aluminium de la couche élémentaire 7 (c'est-à-dire la couche élémentaire en contact avec le substrat 2) vers le substrat 2.

La fraction atomique moyenne en aluminium de la couche élémentaire la plus éloignée du substrat (c'est-à-dire la couche élémentaire qui permet de former la couche protectrice 4) peut être comprise entre 0,22 et 0,35 et de préférence comprise entre 0,25 et 0,3.

Ainsi, la couche protectrice formée exclusivement d'oxyde d'aluminium protecteur peut être formée sur la sous-couche 3, de manière à protéger le superalliage contre l'oxydation et la corrosion.

La fraction atomique moyenne en aluminium de la couche élémentaire 5 la plus proche du substrat peut être inférieure à 0,2 et de préférence peut être comprise entre 0,15 et 0,2. Avantageusement, la fraction atomique moyenne en aluminium de la première couche élémentaire est strictement supérieure à la fraction atomique moyenne en aluminium du substrat. La différence entre la fraction atomique moyenne en aluminium du substrat et la fraction atomique moyenne en aluminium de la couche élémentaire la plus proche du substrat peut être également inférieure à 0,08 et préférentiellement inférieure à 0,06.

Ainsi, la diffusion de l'aluminium vers le substrat est limitée, voire empêchée.

Selon un autre aspect de l'invention, la différence de fraction atomique moyenne en aluminium entre deux couches élémentaires 5 successives est limitée. Elle peut avantageusement être inférieure à 0,06. Ainsi, la diffusion d'aluminium entre deux couches élémentaires 5 successives peut être limitée, voire empêchée. En effet, plus la fraction atomique moyenne en aluminium entre deux couches élémentaires est proche, moins la diffusion d'aluminium entre ces deux couches est élevée.

Le tableau 1 présente la phase allotropique, la fraction atomique en aluminium xⱼ et l'épaisseur de chaque *j*-ième couche élémentaire 5 selon un mode de réalisation de l'invention, *j* étant compris entre 1 et m, m étant un nombre entier naturel désignant le nombre total de couches élémentaires composant la sous-couche 3 métallique.

**Tableau 1**

| | Phase | fraction atomique moyenne en Al (% at) | Épaisseur (µm) |
|---|---|---|---|
| *m*-ième couche élémentaire | γ' | x ₘ= x ₘ₋₁+ (2 à 4) | 1 à 5 |
| ... | ... | ... | ... |
| *(n*+*2*)ième couche élémentaire | γ' | Xₙ₊₂= X ₙ₊₁+ (2 à 4) | 1 à 5 |
| *(n*+*1)*ième couche élémentaire | γ' | Xₙ₊₁= xₙ+(2 à 4) | 1 à 5 |
| *n*-ième couche élémentaire | γ/γ*'* | x ₙ= xₙ₋₁+(2 à 4) | 1 à 5 |
| ... | ... | ... | ... |
| 3^{ème} couche élémentaire | γ/γ' | x₃= x₂+ (2 à 4) | 1 à 5 |
| 2^{nde} couche élémentaire | γ/γ' | X₂= x₁+ (2 à 4) | 1 à 5 |
| 1^{ère} couche élémentaire | γ/γ' | x₁ = xo + (2 à 4) | 1 à 5 |
| Substrat | γ/γ' | x₀ | |

Chaque couche élémentaire peut comporter, outre du nickel Ni et de l'aluminium Al, d'autres éléments chimiques, ou additifs, comme du chrome Cr et du hafnium Hf. Dans le mode de réalisation correspondant au tableau 1, les fractions atomiques moyennes en Cr et Hf, non représentées, sont égales entre les différentes couches élémentaires. En revanche, la fraction atomique moyenne en aluminium d'une couche élémentaire est croissante, c'est-à-dire va en augmentant, à mesure que la couche élémentaire 5 est éloignée du substrat. Réciproquement, la fraction atomique moyenne en nickel d'une couche élémentaire est décroissante, c'est-à-dire va en diminuant, à mesure que la couche élémentaire 5 est éloignée du substrat.

Le tableau 2 présente la phase allotropique, la fraction atomique en aluminium xⱼ et l'épaisseur de chaque *j*-ième couche élémentaire 5 selon un exemple plus particulièrement adapté à l'utilisation du superalliage AM1 et dans lequel m = 7.

**Tableau 2**

| | Phase | fraction atomique moyenne en Al (% at) | Épaisseur (µm) |
|---|---|---|---|
| 7^{ème} couche élémentaire | γ' | x₇= 26 à 28 | 1 à 5 |
| 6^{ème} couche élémentaire | γ' | x₆= 24 à 26 | 1 à 5 |
| 5^{ème} couche élémentaire | γ' | x₅= 22 à 24 | 1 à 5 |
| 4^{ème} couche élémentaire | γ/γ' | x₄= 20 à 22 | 1 à 5 |
| 3^{ème} couche élémentaire | γ/γ' | x₃= 18 à 20 | 1 à 5 |
| 2^{nde} couche élémentaire | γ/γ' | x₂= 16 à 18 | 1 à 5 |
| 1^{ère} couche élémentaire | γ/γ' | x₁ = 14 à 16 | 1 à 5 |
| Substrat AM1 | γ/γ' | x₀= 12 | |

De manière générale, l'épaisseur de chaque couche élémentaire est comprise entre 100 nm et 20 µm.

Selon un mode de réalisation de l'invention, un gradient de fraction atomique moyenne de chrome et/ou de hafnium est généré dans la sous-couche 3. Chacune des couches élémentaires 5 comprend au moins un additif, choisi parmi le chrome et/ou le hafnium, et la fraction atomique moyenne en chrome et/ou en hafnium de chacune des couches élémentaires est croissante, c'est-à-dire va en augmentant à mesure que l'on s'éloigne du substrat.

Ainsi, l'inter-diffusion de chrome et/ou de hafnium d'une couche élémentaire 5 à l'autre est limitée voire empêchée.

Selon un aspect de l'invention, la différence de fraction atomique moyenne en hafnium entre deux couches élémentaires consécutives est avantageusement inférieure à 2. 10⁻⁴ et préférentiellement inférieure à 10⁻⁴. La fraction atomique moyenne en hafnium de la couche élémentaire 5 la plus proche du substrat est avantageusement inférieure à 10.10⁻⁴, préférentiellement inférieure à 5.10⁻⁴. La fraction atomique moyenne en hafnium de la couche élémentaire 5 la plus proche de la couche protectrice 4 est avantageusement comprise entre 0,005 et 0,03, préférentiellement comprise entre 0,01 et 0,02.

Selon un aspect de l'invention dans lequel un gradient de chrome est réalisé dans la sous-couche, la différence de fraction atomique moyenne en chrome entre deux couches élémentaires consécutives est avantageusement comprise entre 0,001 et 0,02, et préférentiellement comprise entre 0,005 et 0,01. La fraction atomique moyenne en chrome de la couche élémentaire 5 la plus proche du substrat est avantageusement inférieure à 0,07. La fraction atomique moyenne en chrome de la couche élémentaire 5 la plus proche de la couche protectrice 4 est avantageusement supérieure à 0,1.

La figure 4 illustre de manière schématique les étapes d'un procédé de fabrication d'une pièce 1 de turbine. Un tel procédé comprend au moins deux étapes :
- une première étape consiste à déposer une première couche élémentaire 7 sur un substrat en superalliage métallique à base nickel monocristallin. La première couche élémentaire déposée comprend une phase γ'-Ni₃Al ainsi qu'éventuellement une phase γ-Ni. La première couche est déposée avec une fraction atomique en aluminium contrôlée x₁. Le matériau de la première couche élémentaire peut être un alliage ou un superalliage métallique base nickel. Avantageusement, la fraction moyenne en aluminium x₁ est strictement supérieure à la fraction moyenne en aluminium x₀ du substrat 2 ;
- une deuxième étape consiste à déposer une deuxième couche élémentaire 8 sur la première couche élémentaire 7. La deuxième couche élémentaire 8 déposée comprend une phase γ'-Ni₃Al ainsi qu'éventuellement une phase γ-Ni. La deuxième couche élémentaire 8 déposée présente une fraction atomique moyenne x₂ strictement supérieure à x₁.

Les étapes sont renouvelées pour déposer un nombre m de couches élémentaires de sorte que la dernière couche élémentaire 5 déposée présente une fraction atomique moyenne prédéterminée. La fraction atomique moyenne prédéterminée est comprise entre 0,22 et 0,35.

Les différentes couches élémentaires 5 de la sous-couche 3 peuvent être déposées physiquement en phase vapeur (procédé de PVD, acronyme du terme anglais *Physical Vapor Deposition*). Différentes méthodes de PVD peuvent être utilisées pour la fabrication de la couche élémentaire 5 telles que la pulvérisation cathodique, l'évaporation joule, l'ablation laser et le dépôt physique en phase vapeur assisté par faisceau d'électrons.

Deux méthodes distinctes peuvent être utilisées pour contrôler précisément les fractions atomiques en chaque élément de chacune des couches élémentaires 5 successives :
- plusieurs cibles de matériaux peuvent être utilisées de manière séquentielle (c'est-à-dire l'une après l'autre), en utilisant une cible pour déposer une couche élémentaire. Chaque cible comprend un matériau dont la composition chimique est celle d'une couche élémentaire 5 correspondante ;
- plusieurs cibles de matériaux peuvent être utilisées en parallèle, de manière simultanée, lors du dépôt d'une ou plusieurs couches élémentaires. Chaque cible peut par exemple comprendre un élément chimique particulier.

Chaque couche peut être déposée par co-évaporation ou par co-pulvérisation : dans ce cas, la vitesse respectivement d'évaporation ou de pulvérisation imposée à chaque cible lors du dépôt d'une couche élémentaire 5 détermine alors la stœchiométrie de ladite couche.

## Revendications

1. Pièce (1) de turbine comprenant :
- un substrat (2) en superalliage base nickel monocristallin, et
- une sous-couche (3) métallique recouvrant le substrat (2),
**caractérisée en ce que** la sous-couche métallique comprend au moins deux couches élémentaires (5), incluant une première couche élémentaire (7) et une deuxième couche élémentaire, la première couche élémentaire étant disposée entre le substrat et la deuxième couche élémentaire, chaque couche élémentaire comprenant une phase γ'-Ni₃Al et **en ce que** la fraction atomique moyenne en aluminium de la deuxième couche élémentaire est strictement supérieure à la fraction atomique moyenne en aluminium de la première couche élémentaire.

2. Pièce (1) de turbine selon la revendication 1, dans laquelle au moins une couche élémentaire comprend une phase γ-Ni.

3. Pièce (1) de turbine selon la revendication 1 à 2, dans laquelle la fraction atomique moyenne en aluminium de la première couche élémentaire est strictement supérieure à la fraction atomique moyenne en aluminium du substrat.

4. Pièce (1) de turbine selon l'une des revendications 1 à 3, dans laquelle la première couche élémentaire comprend une phase γ'-Ni₃Al et une phase γ-Ni, et la sous-couche métallique comprend au moins une autre couche élémentaire comprenant uniquement une phase γ-Ni.

5. Pièce (1) de turbine selon l'une des revendications 1 à 4, dans laquelle la sous-couche métallique comprend une pluralité de couches élémentaires, chaque couche élémentaire comprenant une phase γ'-Ni₃Al, ainsi qu'éventuellement une phase γ-Ni, et en ce que la fraction atomique moyenne en aluminium des couches élémentaires va en augmentant à mesure que l'on s'éloigne du substrat.

6. Pièce (1) de turbine selon l'une des revendications 1 à 5, dans laquelle la fraction atomique moyenne en aluminium de la couche élémentaire la plus éloignée du substrat est comprise entre 0,22 et 0,35.

7. Pièce (1) de turbine selon l'une des revendications 1 à 6, dans laquelle la fraction atomique moyenne en aluminium de la couche élémentaire la plus proche du substrat est inférieure à 0,2.

8. Pièce (1) de turbine selon l'une des revendications 1 à 7, dans laquelle la différence entre la fraction atomique moyenne en aluminium du substrat et la fraction atomique moyenne en aluminium de la couche élémentaire la plus proche du substrat est inférieure à 0,08.

9. Pièce (1) de turbine selon l'une des revendications 1 à 8, dans laquelle la différence entre la fraction atomique moyenne en aluminium de deux couches élémentaires successives est inférieure à 0,06.

10. Pièce (1) de turbine selon l'une des revendications 1 à 9, dans laquelle chaque couche élémentaire comprend au moins un additif choisi parmi du chrome et duhafnium, et dans laquelle la fraction atomique moyenne en additif des couches élémentaires va en augmentant à mesure que l'on s'éloigne du substrat.

11. Pièce (1) de turbine selon la revendication 10, dans laquelle chaque couche élémentaire comprend du hafnium, et dans laquelle la différence entre la fraction atomique moyenne en hafnium de deux couches élémentaires successives est inférieure à 0,001.

12. Pièce (1) de turbine selon l'une des revendications 10 à 11, dans laquelle la fraction atomique moyenne en hafnium de la couche élémentaire la plus éloignée du substrat est inférieure à 0,03 et la fraction atomique moyenne en hafnium de la couche élémentaire la plus proche du substrat est supérieure à 0,0005.

13. Procédé de fabrication d'une pièce de turbine (1) comprenant des étapes de :
a) dépôt d'une première couche élémentaire (7) comprenant une phase γ'-Ni₃Al, ainsi qu'éventuellement une phase γ-Ni, et présentant une fraction atomique moyenne en aluminium x₁, sur un substrat (2) en superalliage métallique à base nickel monocristallin ;
b) dépôt d'une deuxième couche élémentaire (8) comprenant une phase γ'-Ni₃Al, ainsi qu'éventuellement une phase γ-Ni, et présentant une fraction atomique moyenne en aluminium x₂ strictement supérieure à x₁ sur la première couche élémentaire.

14. Procédé selon la revendication précédente, dans lequel la première couche élémentaire présente une fraction atomique moyenne en aluminium x₁ strictement supérieure à la fraction atomique moyenne en aluminium x₀ du superalliage base nickel du substrat.

## Patentansprüche

1. Turbinenkomponente (1), umfassend:
- ein Substrat (2) aus Superlegierung auf der Basis von monokristallinem Nickel, und
- eine metallische Unterschicht (3), die das Substrat (2) bedeckt,
**dadurch gekennzeichnet, dass** die metallische Unterschicht mindestens zwei elementare Schichten (5) umfasst, die eine erste elementare Schicht (7) und eine zweite elementare Schicht einschließen, wobei die erste elementare Schicht zwischen dem Substrat und der zweiten elementaren Schicht angeordnet ist, wobei jede elementare Schicht eine Phase γ'-Ni₃Al umfasst und dass der mittlere Aluminium-Atomanteil der zweiten elementaren Schicht strikt größer als der mittlere Aluminium-Atomanteil der ersten elementaren Schicht ist.

2. Turbinenkomponente (1) nach Anspruch 1, wobei mindestens eine elementare Schicht eine Phase γ-Ni umfasst.

3. Turbinenkomponente (1) nach Anspruch 1 bis 2, wobei der mittlere Aluminium-Atomanteil der ersten elementaren Schicht strikt größer als der mittlere Aluminium-Atomanteil des Substrats ist.

4. Turbinenkomponente (1) nach einem der Ansprüche 1 bis 3, wobei die erste elementare Schicht eine Phase γ'-Ni₃Al und eine Phase γ-Ni umfasst, und die metallische Unterschicht mindestens eine andere elementare Schicht umfasst, die nur eine Phase γ-Ni umfasst.

5. Turbinenkomponente (1) nach einem der Ansprüche 1 bis 4, wobei die metallische Unterschicht eine Vielzahl von elementaren Schichten umfasst, wobei jede elementare Schicht eine Phase γ'-Ni₃Al sowie eventuell eine Phase γ-Ni umfasst, und dass der mittlere Aluminium-Atomanteil der elementaren Schichten mit zunehmender Entfernung vom Substrat zunimmt.

6. Turbinenkomponente (1) nach einem der Ansprüche 1 bis 5, wobei der mittlere Aluminium-Atomanteil der elementaren Schicht, die vom Substrat am weitesten entfernt ist, zwischen 0,22 und 0,35 liegt.

7. Turbinenkomponente (1) nach einem der Ansprüche 1 bis 6, wobei der mittlere Aluminium-Atomanteil der elementaren Schicht, die dem Substrat am nächsten ist, kleiner als 0,2 ist.

8. Turbinenkomponente (1) nach einem der Ansprüche 1 bis 7, wobei die Differenz zwischen dem mittleren Aluminium-Atomanteil des Substrats und dem mittleren Aluminium-Atomanteil der elementaren Schicht, die dem Substrat am nächsten ist, kleiner als 0,08 ist.

9. Turbinenkomponente (1) nach einem der Ansprüche 1 bis 8, wobei die Differenz zwischen dem mittleren Aluminium-Atomanteil von zwei aufeinanderfolgenden elementaren Schichten kleiner als 0,06 ist.

10. Turbinenkomponente (1) nach einem der Ansprüche 1 bis 9, wobei jede elementare Schicht mindestens ein Additiv umfasst, ausgewählt aus Chrom und Hafnium, und wobei der mittlere Additiv-Atomanteil der elementaren Schichten mit zunehmender Entfernung vom Substrat zunimmt.

11. Turbinenkomponente (1) nach Anspruch 10, wobei jede elementare Schicht Hafnium umfasst und wobei die Differenz zwischen dem mittleren Hafnium-Atomanteil von zwei aufeinanderfolgenden elementaren Schichten kleiner als 0,001 ist.

12. Turbinenkomponente (1) nach einem der Ansprüche 10 bis 11, wobei der mittlere Hafnium-Atomanteil der elementaren Schicht, die am weitesten vom Substrat entfernt ist, kleiner als 0,03 ist, und der mittlere Hafnium-Atomanteil der elementaren Schicht, die dem Substrat am nächsten ist, größer als 0,0005 ist.

13. Verfahren zur Herstellung einer Turbinenkomponente (1), umfassend die Schritte:
a) Aufbringen einer ersten elementaren Schicht (7), die eine Phase γ'-Ni₃Al sowie eventuell eine Phase γ-Ni umfasst, und einen mittleren Aluminium-Atomanteil x₁ aufweist, auf ein Substrat (2) aus metallischer Superlegierung auf der Basis von monokristallinem Nickel;
b) Aufbringen einer zweiten elementaren Schicht (8), die eine Phase γ'-Ni₃Al sowie eventuell eine Phase γ-Ni umfasst, und einen mittleren Aluminium-Atomanteil x₂ aufweist, der strikt größer als ist, auf die erste elementare Schicht.

14. Verfahren nach vorangehendem Anspruch, wobei die erste elementare Schicht einen mittleren Aluminium-Atomanteil x₁ aufweist, der strikt größer als der mittlere Aluminium-Atomanteil x₀ der Superlegierung auf der Basis von Nickel des Substrats ist.

## Claims

1. Turbine component (1) comprising:
- a single-crystal nickel-based superalloy substrate (2), and
- a metallic bond coat (3) covering the substrate (2),
**characterized in that** the metallic bond coat comprises at least two elemental layers (5), including a first elemental layer (7) and a second elemental layer, the first elemental layer being disposed between the substrate and the second elemental layer, each elemental layer comprising a γ'-Ni₃Al phase and **in that** the average atomic fraction of aluminium in the second elemental layer is strictly higher than the average atomic fraction of aluminium in the first elemental layer.

2. Turbine component (1) according to claim 1, wherein at least one elemental layer comprises a γ-Ni phase.

3. Turbine component (1) according to claim 1 to 2, wherein the average atomic fraction of aluminium in the first elemental layer is strictly higher than the average atomic fraction of aluminium in the substrate.

4. Turbine component (1) according to one of claims 1 to 3, wherein the first elemental layer comprises a γ'-Ni₃Al phase and a γ-Ni phase, and the metallic bond coat comprises at least one further elemental layer comprising only a y-Ni phase.

5. Turbine component (1) according to one of claims 1 to 4, wherein the metallic bond coat comprises a plurality of elemental layers, each elemental layer comprising a γ'-Ni₃Al phase, and possibly a γ-Ni phase, and that the average atomic fraction of aluminium in the elemental layers increases with distance from the substrate.

6. Turbine component (1) according to one of claims 1 to 5, wherein the average atomic fraction of aluminium in the elemental layer furthest from the substrate is between 0.22 and 0.35.

7. Turbine component (1) according to one of claims 1 to 6, wherein the average atomic fraction of aluminium in the elemental layer closest to the substrate is less than 0.2.

8. Turbine component (1) according to one of claims 1 to 7, wherein the difference between the average atomic fraction of aluminium in the substrate and the average atomic fraction of aluminium in the elemental layer closest to the substrate is less than 0.08.

9. Turbine component (1) according to one of claims 1 to 8, wherein the difference between the average atomic fraction of aluminium in two successive elemental layers is less than 0.06.

10. Turbine component (1) according to one of claims 1 to 9, wherein each elemental layer comprises at least one additive selected from chromium and hafnium, and wherein the average atomic fraction of additive in the elemental layers increases with distance from the substrate.

11. Turbine component (1) according to claim 10, wherein each elemental layer comprises hafnium, and wherein the difference between the average atomic fraction of hafnium in two successive elemental layers is less than 0.001.

12. Turbine component (1) according to one of claims 10 to 11, wherein the average atomic fraction of hafnium in the elemental layer furthest from the substrate is less than 0.03 and the average atomic fraction of hafnium in the elemental layer nearest the substrate is greater than 0.0005.

13. Process for fabricating a turbine component (1) comprising steps of:
a) deposition of a first elemental layer (7) comprising a γ'-Ni₃Al phase, and possibly a γ-Ni phase, and having an average atomic fraction of aluminium x₁, on a single-crystal nickel-based metallic superalloy substrate (2);
b) deposition of a second elemental layer (8) comprising a γ'-Ni₃Al phase, and possibly a y-Ni phase, and having an average atomic fraction of aluminium x₂ strictly greater than x₁ on the first elemental layer.

14. Process according to the preceding claim, wherein the first elemental layer has an average atomic fraction of aluminium x₁. strictly higher than the average atomic fraction of aluminium x₀ in the nickel-based superalloy of the substrate.
